# EUROPÄISCHE PATENTANMELDUNG

(11) **EP 4 586 155 A1**
(43) Veröffentlichungstag der Anmeldung: **16.07.2025**
(21) Anmeldenummer: 24151586.5
(22) Anmeldetag: 12.01.2024
(51) Int. Cl.: G06N 20/00, G01R 31/367, G01R 31/392

(54) **VERFAHREN UND SYSTEM ZUM TRAINIEREN EINES GENETISCH-SYMBOLISCHEN REGRESSIONSMODELLS**

(71) Anmelder: Robert Bosch GmbH, 70442 Stuttgart (DE)
(72) Erfinder: Moga, Elena-Anda, 400624 Napoca, Cluj (RO)

(57) **Zusammenfassung**

Die Erfindung betrifft ein Verfahren zum Trainieren eines genetisch-symbolischen Regressionsmodells zur Ursachenermittlung einer Degradation eines Energiespeichers, das Verfahren aufweisend: Bereitstellen (S1) von Trainingsdaten, umfassend Betriebsdaten und/oder Betriebsparameter des Energiespeichers; Generieren (S2), mittels des genetisch-symbolischen Regressionsmodells, einer Zufallsbaum-Population von Gleichungen zur Ursachenermittlung der Degradation; Auswählen (S3a) von mindestens zwei Zufallsbaum-Gleichungen der Zufallsbaum-Population von Gleichungen, zum Kreuzen (S4a) der mindestens zwei Zufallsbaum-Gleichungen zum Erzeugen von mindestens einer gekreuzten Zufallsbaum-Gleichung; und/oder
- Auswählen (S3b) von mindestens einer Zufallsbaum-Gleichung der Zufallsbaum-Population von Gleichungen, zum Mutieren (S4b) der mindestens einen Zufallsbaum-Gleichung zum Erzeugen von mindestens einer mutierten Zufallsbaum-Gleichung;
- Hinzufügen (S5) der gekreuzten und/oder mutierten Zufallsbaum-Gleichung zu der Zufallsbaum-Population von Gleichungen; Durchführen (S6) der Schritte (S3) bis (S5) für eine vorbestimmte Anzahl (n) von Generationen; und Auswählen (S7) derjenigen Zufallsbaum-Gleichung aus der Zufallsbaum-Population von Gleichungen, die basierend auf einer Bewertungsmetrik die beste Ursachenermittlung der Degradation des Energiespeichers angibt, um derart das trainierte genetisch-symbolische Regressionsmodell bereitzustellen.

## Beschreibung

Die Erfindung betrifft ein Verfahren und ein System zum Trainieren eines genetisch-symbolischen Regressionsmodells zur Ursachenermittlung einer Degradation eines Energiespeichers. Die Erfindung betrifft die Verwendung eines trainierten genetisch-symbolischen Regressionsmodells zur Ursachenermittlung einer Degradation eines Energiespeichers. Die Erfindung betrifft ein Computerprogramm mit Programmcode sowie einen computerlesbaren Datenträger mit Programmcode.

### Stand der Technik

Die Optimierung der Lebensdauer von Energiespeichern ist von entscheidender Bedeutung, um die Effizienz und Wirtschaftlichkeit von Energiespeichersystemen zu gewährleisten. Diese Systeme spielen eine immer wichtigere Rolle in der modernen Energieversorgung, da sie die Integration erneuerbarer Energiequellen erleichtern und die Stabilität des Stromnetzes verbessern.

Eine entscheidende Herausforderung bei der Maximierung der Lebensdauer von Energiespeichern besteht darin, die zugrunde liegenden Ursachen für die Degradation zu verstehen und zu minimieren. Diese Ursachen sind eng mit den spezifischen Betriebsbedingungen des Energiespeichers verbunden und erfordern eine umfassende Analyse sowie gezielte Maßnahmen zur Prävention und Wartung.

Aus der Literatur sind verschiedene Ursachenanalysen bekannt, um Degradationseffekte zu ermitteln und/oder abzuschätzen. Es ist allerdings weiterhin Optimierungspotenzial vorhanden.

Der Erfindung liegt die Aufgabe zugrunde, eine verbesserte Ursachenermittlung einer Degradation eines Energiespeichers bereitzustellen.

Die Aufgabe wird gelöst durch ein Verfahren zum Trainieren eines genetisch-symbolischen Regressionsmodells zur Ursachenermittlung einer Degradation eines Energiespeichers gemäß den Merkmalen des Patentanspruchs 1. Die Aufgabe wird gelöst durch ein System zum Trainieren eines genetisch-symbolischen Regressionsmodells zur Ursachenermittlung einer Degradation eines Energiespeichers gemäß den Merkmalen des Patentanspruchs 12.

### Offenbarung der Erfindung

Gemäß einem ersten Aspekt wird ein Verfahren zum Trainieren eines genetisch-symbolischen Regressionsmodells zur Ursachenermittlung einer Degradation eines Energiespeichers angegeben, das Verfahren aufweisend:
- Bereitstellen von Trainingsdaten, umfassend Betriebsdaten und/oder Betriebsparameter des Energiespeichers;
- Generieren, mittels des genetisch-symbolischen Regressionsmodells, einer Zufallsbaum-Population von Gleichungen zur Ursachenermittlung der Degradation;
- Auswählen von mindestens zwei Zufallsbaum-Gleichungen der Zufallsbaum-Population von Gleichungen, zum Kreuzen der mindestens zwei Zufallsbaum-Gleichungen zum Erzeugen von mindestens einer gekreuzten Zufallsbaum-Gleichung; und/oder
- Auswählen von mindestens einer Zufallsbaum-Gleichung der Zufallsbaum-Population von Gleichungen, zum Mutieren der mindestens einen Zufallsbaum-Gleichung zum Erzeugen von mindestens einer mutierten Zufallsbaum-Gleichung;
- Hinzufügen der gekreuzten und/oder mutierten Zufallsbaum-Gleichung zu der Zufallsbaum-Population von Gleichungen;
- Durchführen der Schritte S3 bis S5 für eine vorbestimmte Anzahl von Generationen; und
- Auswählen derjenigen Zufallsbaum-Gleichung aus der Zufallsbaum-Population von Gleichungen, die basierend auf einer Bewertungsmetrik die beste Ursachenermittlung der Degradation des Energiespeichers angibt, um derart das trainierte genetisch-symbolische Regressionsmodell bereitzustellen.

Es versteht sich, dass die erfindungsmäßen Schritte sowie weitere optionale Schritte nicht notwendigerweise in der aufgezeigten Reihenfolge ausgeführt werden müssen, sondern auch in einer anderen Reihenfolge ausgeführt werden können. Ferner können weitere Zwischenschritte vorgesehen sein. Die einzelnen Schritte können zudem einen oder mehrere Unterschritte umfassen, ohne dass hierdurch der Umfang des erfindungsgemäßen Verfahrens verlassen wird.

Gemäß einem zweiten Aspekt wird ein System zum Trainieren eines genetisch-symbolischen Regressionsmodells zur Ursachenermittlung einer Degradation eines Energiespeichers angegeben, das System aufweisend eine Auswerte- und/oder Recheneinrichtung, die dazu ausgebildet ist, mindestens die nachfolgenden Schritte auszuführen:
- Bereitstellen von Trainingsdaten, umfassend Betriebsdaten und/oder Betriebsparameter des Energiespeichers;
- Generieren, mittels des genetisch-symbolischen Regressionsmodells, einer Zufallsbaum-Population von Gleichungen zur Ursachenermittlung der Degradation;
- Auswählen von mindestens zwei Zufallsbaum-Gleichungen der Zufallsbaum-Population von Gleichungen, zum Kreuzen der mindestens zwei Zufallsbaum-Gleichungen zum Erzeugen von mindestens einer gekreuzten Zufallsbaum-Gleichung; und/oder
- Auswählen von mindestens einer Zufallsbaum-Gleichung der Zufallsbaum-Population von Gleichungen, zum Mutieren der mindestens einen Zufallsbaum-Gleichung zum Erzeugen von mindestens einer mutierten Zufallsbaum-Gleichung;
- Hinzufügen der gekreuzten und/oder mutierten Zufallsbaum-Gleichung zu der Zufallsbaum-Population von Gleichungen;
- Durchführen der Schritte S3 bis S5 für eine vorbestimmte Anzahl von Generationen; und
- Auswählen derjenigen Zufallsbaum-Gleichung aus der Zufallsbaum-Population von Gleichungen, die basierend auf einer Bewertungsmetrik die beste Ursachenermittlung der Degradation des Energiespeichers angibt, um derart das trainierte genetisch-symbolische Regressionsmodell bereitzustellen.

Mittels des genetisch-symbolischen Regressionsmodells wird eine Zufallsbaum-Population von Gleichungen generiert. Diese Gleichungen dienen dazu, die Ursachen der Degradation des Energiespeichers zu identifizieren. Zum genetischen Optimieren der erzeugten Zufallsbaum-Gleichungen können mindestens zwei Zufallsbaum-Gleichungen aus der Population ausgewählt und miteinander gekreuzt werden, um mindestens eine gekreuzte Zufallsbaum-Gleichung zu erzeugen. Alternativ oder ergänzend kann mindestens eine Zufallsbaum-Gleichung aus der Population ausgewählt und mutiert werden, um mindestens eine mutierte Zufallsbaum-Gleichung zu erzeugen. Die derart erzeugten, gekreuzten und/oder mutierten Zufallsbaum-Gleichungen werden zur Zufallsbaum-Population von Gleichungen hinzugefügt. Das Verfahren wird, ähnlich zu der evolutionären Entwicklung, für eine bestimmte Anzahl von Malen bzw. Generationen durchgeführt. Die jeweils um die gekreuzten und/oder mutierten Zufallsbaum-Gleichungen ergänzte Population von Zufallsbaum-Gleichungen wird somit vorzugsweise mit jedem Durchlauf bzw. mit jeder Generation optimiert, so dass letztlich eine optimierte Zufallsbaum-Gleichung ausgewählt werden kann. Die für die Kreuzung und/oder Mutation getroffene Auswahl von Gleichungen wird vorzugsweise ebenfalls mit jeder Evolutionsstufe verbessert. Die Schritte 3 bis 5 werden also für eine vorbestimmte Anzahl von Generationen wiederholt. Am Ende des Trainingsprozesses wird vorzugsweise diejenige Zufallsbaum-Gleichung aus der Population ausgewählt, die basierend auf einer Bewertungsmetrik die beste Ursachenermittlung für die Degradation des Energiespeichers liefert. Insgesamt dient das Verfahren dazu, ein genetisch-symbolisches Regressionsmodell zu erstellen, das die Ursachen für die Degradation eines Energiespeichers identifiziert und somit zur Optimierung der Lebensdauer des Energiespeichers beiträgt.

Ein genetisch-symbolisches Regressionsmodell ist vorzugsweise ein maschinelles Lernmodell, das dazu verwendet wird, Beziehungen zwischen Eingangsvariablen (in diesem Fall Betriebsdaten und/oder Betriebsparameter eines Energiespeichers) und einer Zielgröße (in diesem Fall die Degradation des Energiespeichers) zu modellieren. Dieses Modell verwendet genetische Algorithmen und symbolische Regressionstechniken, um mathematische Gleichungen zu erstellen, die die Beziehung zwischen den Variablen repräsentieren. Diese Gleichungen können dazu beitragen, die Ursachen für die Degradation des Energiespeichers zu identifizieren und vorherzusagen.

Die "Anzahl von Generationen" bezieht sich auf die Anzahl der Iterationen oder Wiederholungen, die im genetischen Algorithmus durchgeführt werden, um das Regressionsmodell zu trainieren und zu optimieren. Jede Generation entspricht einem Durchlauf des genetischen Algorithmus, in dem Zufallsbaum-Gleichungen erzeugt, gekreuzt, mutiert und bewertet werden. Durch die wiederholte Ausführung dieser Schritte über eine festgelegte Anzahl von Generationen hinweg verbessert sich das Modell schrittweise, bis eine akzeptable Lösung gefunden wird.

Zufallsbaum-Gleichungen sind mathematische Ausdrücke oder Gleichungen, die durch den genetischen Algorithmus generiert und manipuliert werden, um die Beziehung zwischen den Eingangsvariablen und der Zielgröße zu repräsentieren. Diese Gleichungen bestehen aus Verzweigungen und Knoten, ähnlich wie Entscheidungsbäume. Während des Trainingsprozesses werden diese Zufallsbaum-Gleichungen ausgewählt, gekreuzt, mutiert und bewertet, um die beste Gleichung zu finden, die die Degradation des Energiespeichers am besten erklärt. Die Verwendung von Zufallsbaum-Gleichungen ermöglicht es, komplexe Beziehungen zwischen den Variablen zu modellieren und die Ursachen für die Degradation zu identifizieren.

Es gibt vorzugsweise verschiedene Bewertungsmetriken, die für die Evaluierung und Auswahl der besten Zufallsbaum-Gleichung in einem genetisch-symbolischen Regressionsmodell verwendet werden können. Beispielsweise kann als Bewertungsmetrik eine mittlere quadratische Abweichung (Mean Squared Error, MSE) verwendet werden. Die MSE-Metrik misst die durchschnittliche quadratische Abweichung zwischen den vom Modell vorhergesagten Werten und den tatsächlichen Beobachtungen. Ein niedriger MSE-Wert deutet auf eine gute Anpassung des Modells an die Daten hin. Alternativ oder ergänzend kann eine R² (R-Squared) Metrik verwendet werden. Das R²-Maß, auch als Bestimmtheitsmaß bekannt, gibt an, wie gut die Variationen in den Zielgrößen durch das Modell erklärt werden. Ein höherer R²-Wert (in der Nähe von 1) zeigt an, dass das Modell die Daten gut erklärt. Alternativ oder ergänzend kann eine Root Mean Squared Error (RMSE) Metrik verwendet werden. Der RMSE ist die Quadratwurzel des MSE und gibt an, wie weit die vorhergesagten Werte im Durchschnitt von den tatsächlichen Werten entfernt sind. Ein niedriger RMSE-Wert deutet auf eine präzise Vorhersage hin. Alternativ oder ergänzend kann eine Adjusted R² Metrik verwendet werden. Das angepasste R² berücksichtigt die Anzahl der verwendeten Prädiktoren und bestraft Modelle, die viele Variablen verwenden, die keine zusätzliche Erklärungskraft bieten. Es ist nützlich, um Overfitting zu vermeiden.

Alternativ oder ergänzend kann eine Information Criteria (z. B. AIC, BIC) verwendet werden. Information Criteria wie das Akaike Information Criterion (AIC) und das Bayesian Information Criterion (BIC) ermöglichen die Auswahl eines Modells unter Berücksichtigung der Modellkomplexität. Sie strafen Modelle mit zu vielen Parametern und fördern parsimonische Modelle. Alternativ oder ergänzend kann eine Kreuzvalidierung verwendet werden. Kreuzvalidierungstechniken wie die k-fache Kreuzvalidierung können verwendet werden, um die Modellleistung auf unabhängigen Datensätzen zu testen. Sie teilen die Daten in Trainings- und Testsets auf, um die Generalisierungsfähigkeit des Modells zu bewerten.

Das Verfahren betrifft also eine sogenannte Root Cause Analysis für Degradation von insbesondere chemischen Energiespeichern. Dabei wird das Verwenden eines Genetic Symbolic Regression Modells vorgeschlagen, um Gleichungen zur mathematischen Modellierung der Degradation zu ermitteln. Aus den Gleichungen kann bestimmt werden, welche Größe den stärksten Einfluss auf die Degradation hatte.

Die genetisch-symbolische Regression kann verwendet werden, um die Ursachen der Degradation eines Energiespeichers zu ermitteln, indem die wichtigsten Merkmale, die zur Degradation beitragen, gefunden und die Beziehungen zwischen ihnen datengesteuert abgebildet werden. Unter Verwendung der Betriebsdaten des Energiespeichers kann ein genetischer symbolischer Regressionsmodell trainiert werden, um die Beziehung zwischen den Merkmalen und der Ausgangsspannung bei Degradation abzubilden. Das Modell erfasst dabei vorzugsweise Faktoren, die zur Degradation des Energiespeichers beitragen, indem es die am besten geeignete mathematische Zufallsbaum-Gleichung auswählt, durch die eine abhängige Degradationsvariable, beispielsweise eine Spannungsvariable, bestimmt wird.

Die Analyse der Gleichung hebt die wichtigsten Merkmale hervor und zeigt, wie sie zum Ergebnis beitragen. Das Modell erstellt dabei nach dem Zufallsprinzip eine Population von Zufallsbaum-Gleichungen, indem es Merkmale und/oder mathematische Operationen, die einen Einfluss auf die Degradation haben können, miteinander und/oder untereinander kombiniert. Für eine bestimmte Anzahl von Generationen werden die am besten geeigneten Individuen bzw. Zufallsbaum-Gleichungen der Population, insbesondere die Gleichungen mit der besten Leistung, für eine Kreuzung und/oder eine Mutation ausgewählt.

Der Hauptvorteil dieses Ansatzes im Vergleich zu anderen Regressionsalgorithmen besteht darin, dass die Ergebnisse aufgrund der Zufallsbaum-Darstellung eine interpretierbare Darstellung haben, die die Grundursachen der Degradation aufdecken kann und ein Modell liefert, das leicht überprüft und dem vertraut werden kann. Ein weiterer Vorteil ist die Vielfalt der Population, die durch den Mutationsprozess erzeugt wird. Während die bevorzugte Kreuzung einen inhärenten Optimierungsschritt darstellt, da die Kreuzung zwei am besten geeignete Zufallsbaum-Gleichungen kombiniert, verändert Mutation zufällig einen Teil der Gleichung und stellt sicher, dass der Algorithmus lokale Optima vermeidet.

Die für das Verfahren gemachten Ausführungen gelten für das System entsprechend. Dabei versteht es sich, dass sprachliche Abwandlungen von verfahrensmäßig formulierten Merkmalen nach sprachüblicher Praxis für das System umformulierbar sind, ohne dass derartige Formulierungen explizit hier aufgeführt werden müssen.

In einer Ausführungsform weisen die Betriebsdaten und/oder Betriebsparameter einen zeitreihenbasierten Betriebsstrom und/oder eine zeitreihenbasierte Betriebstemperatur und/oder eine zeitreihenbasierte Beschleunigung und/oder eine zeitreihenbasierte Betriebs- und/oder Zellspannung auf. Grundsätzlich sind auch weitere Parameter wie eine Umgebungstemperatur und/oder Umgebungsbedingungen und/oder mechanische Spannungen und/oder Druckverläufe und/oder Umgebungsdrücke als Betriebsdaten und/oder Betriebsparameter möglich.

In einer Ausführungsform weist das Kreuzen ein Kombinieren der mindestens zwei Zufallsbaum-Gleichungen, insbesondere unter Berücksichtigung von mindestens einer Randbedingung und/oder einer Leistung bei der Ursachenermittlung auf.

In einer Ausführungsform weist das Mutieren ein zufälliges Verändern und/oder Kombinieren mindestens eines Teils der mindestens einen Zufallsbaum-Gleichung auf.

Bei der Kreuzung werden die beiden am besten geeigneten Individuen kombiniert, während bei der Mutation ein kleiner Teil der Gleichung zufällig verändert wird. In einer symbolischen Darstellung bedeutet dies die Entfernung oder Ersetzung eines Knotens in einem Zufallsbaum oder eines Teilbaums eines Zufallsbaums.

In einer Ausführungsform wird zum Optimieren des genetisch-symbolischen Regressionsmodells eine Hyperparameteranpassung und/oder eine Hyperparameteranalyse während des nach Abschluss oder während Modelltrainings durchgeführt.

Hyperparameter sind vorzugsweise Einstellungen oder Konfigurationen, die nicht aus den Daten selbst gelernt werden, sondern vor dem Modelltraining festgelegt werden müssen. Sie beeinflussen, wie das Modell trainiert wird, und können die Leistung und das Verhalten des Modells erheblich beeinflussen. Die "Hyperparameteranpassung" bezieht sich vorzugsweise auf die Anpassung und/oder Änderung der Hyperparameter, um die Modellleistung zu verbessern. Dies kann manuell durchgeführt werden oder automatisch mithilfe von Optimierungsalgorithmen. Die "Hyperparameteranalyse" bezieht sich vorzugsweise auf die Untersuchung der Auswirkungen verschiedener Hyperparametereinstellungen auf die Modellleistung.

Dies kann Experimente mit verschiedenen Konfigurationen und deren Auswirkungen auf die Modellgenauigkeit und -robustheit beinhalten. Die Hyperparameteranpassung oder -analyse wird entweder nach Abschluss des Modelltrainings oder während des Modelltrainings selbst durchgeführt. Dies ermöglicht es, das Modell kontinuierlich zu optimieren und an sich ändernde Anforderungen anzupassen.

Obwohl der Mutationsprozess eine inhärent eine gewisse Vielfalt in die Population der Zufallsbaum-Gleichungen bringt und die Suche nach Degradationseffekte und/oder Degradationseinflüssen auf verschiedene Bereiche ausdehnt, garantiert er nicht ohne weiteres, dass ein globales Optimum für die Gesamtheit der zufällig erzeugten Zufallsbaum-Gleichungen erhalten wird. Um eine optimale Lösung zu erreichen, wird vorzugsweise das Modell mehrfach mit einer randomisierten bzw. zufälligen oder auch vorbestimmten Hyperparametersuche ausgeführt, wobei vorzugsweise eine beträchtliche Populationsgröße und Anzahl von Generationen beibehalten wird.

In einer Ausführungsform weist der Energiespeicher einen elektrischen Energiespeicher oder einen elektro-chemischen Energiespeicher oder einen elektro-mechanischen Energiespeicher auf.

Der Begriff "Energiespeicher" bezieht sich auf eine Vorrichtung oder Einrichtung, die dazu dient, insbesondere elektrische Energie zu speichern und bei Bedarf wieder abzugeben. "Elektrischer Energiespeicher" bezieht sich auf einen Energiespeicher, der elektrische Energie in Form von elektrischem Strom speichert und abgibt. Beispiele für elektrische Energiespeicher sind Batterien und Kondensatoren. "Elektro-chemischer Energiespeicher" bezieht sich auf einen Energiespeicher, bei dem die Energiespeicherung und -freisetzung durch chemische Reaktionen erfolgt, die in einem elektrochemischen Prozess stattfinden. Batterien sind ein typisches Beispiel für elektrochemische Energiespeicher. "Elektro-mechanischer Energiespeicher" bezieht sich auf einen Energiespeicher, bei dem die Energie in mechanischer Form, beispielsweise als kinetische Energie, gespeichert wird und dann in elektrische Energie umgewandelt werden kann. Ein Beispiel hierfür ist ein Schwungradspeicher.

In einer Ausführungsform weist der elektrische Energiespeicher eine Batterie oder eine Brennstoffzelle auf.

Besonders bevorzugt ist das Verfahren dabei zur Ursachenermittlung einer Stackdegradation der Brennstoffzelle und/oder der Batterie ausgebildet. Besonders bevorzugt kann das Verfahren bzw. das trainierte Modell für die Ermittlung und/oder Vorhersage und/oder Bestimmung der Degradation von Brennstoffzellenstapeln und/oder Batteriezellen und/oder Batterie-Modulen, auch in einem Energiespeicherverbund, verwendet werden.

In einer Ausführungsform weist das Verfahren ferner den Schritt auf: Durchführen einer Merkmalswichtigkeitsanalyse bezüglich der in Schritt S7 ausgewählten Zufallsbaum-Gleichung.

Das sich durch das Training ergebende Modell bzw. die ausgewählte Gleichung kann verwendet werden, um Informationen über potenzielle Grundursachen der Degradation zu extrahieren, indem eine, insbesondere automatische, Analyse der Bedeutung von Merkmalen der ausgewählten Gleichung durchgeführt wird.

In einer Ausführungsform weist die Merkmalswichtigkeitsanalyse ein Erzeugen mindestens einer partiellen Ableitung der in Schritt S7 ausgewählten Zufallsbaum-Gleichung in Bezug auf mindestens eine Gleichungsvariable auf.

Da das trainierte Modell ein mathematischer Ausdruck von Merkmalen, die die Degradation beeinflussen, ist, kann die Wichtigkeit vorzugsweise durch einen partiellen Effekt bestimmt werden, d. h. durch die partiellen Ableitungen der ausgewählten Gleichung und/oder einer ihrer Teil-Funktionen in Bezug auf eine bestimmte Variable. Damit wird das Ausmaß der Änderung des Outputs der Gleichung messbar, das durch die Änderung einer unabhängigen Variablen verursacht wird, während die anderen Merkmale unverändert bleiben.

In einer Ausführungsform weist die Merkmalswichtigkeitsanalyse ein Analysieren der dem Schritt S7 ("Auswählen (S7) derjenigen Zufallsbaum-Gleichung aus der Zufallsbaum-Population von Gleichungen, die basierend auf einer Bewertungsmetrik die beste Ursachenermittlung der Degradation des Energiespeichers angibt, um derart das trainierte genetisch-symbolische Regressionsmodell bereitzustellen") zugrundeliegenden Zufallsbaum-Population von Gleichungen auf.

Ein weiterer Ansatz zur Bestimmung der Bedeutung von Merkmalen ist die Analyse der endgültigen Population und/oder der Entwicklung der Population über einige Generationen. Die Häufigkeit der in der endgültigen Population vorhandenen Merkmale kann ein Indikator für die Wichtigkeit sein, insbesondere wenn der Durchschnitt über mehrere Läufe gebildet wird.

Vorliegend wird auch die Verwendung des vorliegend trainierten genetisch-symbolischen Regressionsmodells zur Ursachenermittlung einer Degradation eines Energiespeichers beansprucht.

Vorliegend ist auch ein Computerprogramm mit Programmcode beansprucht, um zumindest Teile des erfindungsgemäßen Verfahrens in einer seiner Ausführungsformen auszuführen, wenn das Computerprogramm auf einem Computer ausgeführt wird. Mit anderen Worten wird erfindungsgemäß ein Computerprogramm(-produkt), umfassend Befehle, die bei der Ausführung des Programms durch einen Computer diesen veranlassen, das Verfahren/die Schritte des erfindungsgemäßen Verfahrens in einer seiner Ausführungsformen auszuführen.

Vorliegend ist auch ein computerlesbarer Datenträger mit Programmcode eines Computerprogramms vorgeschlagen, um zumindest Teile des erfindungsgemäßen Verfahrens in einer seiner Ausführungsformen auszuführen, wenn das Computerprogramm auf einem Computer ausgeführt wird. Mit anderen Worten betrifft die Erfindung ein computerlesbares (Speicher-) Medium, umfassend Befehle, die bei der Ausführung durch einen Computer diesen veranlassen, das Verfahren/die Schritte des erfindungsgemäßen Verfahrens in einer seiner Ausführungsformen auszuführen.

Die beschriebenen Ausgestaltungen und Weiterbildungen lassen sich beliebig miteinander kombinieren.

Weitere mögliche Ausgestaltungen, Weiterbildungen und Implementierungen der Erfindung umfassen auch nicht explizit genannte Kombinationen von zuvor oder im Folgenden bezüglich der Ausführungsbeispiele beschriebenen Merkmalen der Erfindung.

### Kurze Beschreibung der Zeichnungen

Die beiliegenden Zeichnungen sollen ein weiteres Verständnis der Ausführungsformen der Erfindung vermitteln. Sie veranschaulichen Ausführungsformen und dienen im Zusammenhang mit der Beschreibung der Erklärung von Prinzipien und Konzepten der Erfindung.

Andere Ausführungsformen und viele der genannten Vorteile ergeben sich im Hinblick auf die Zeichnungen. Die dargestellten Elemente der Zeichnungen sind nicht notwendigerweise maßstabsgetreu zueinander gezeigt.

Es zeigen:
- Fig. 1: ein schematisches Flussdiagram eines Ausführungsbeispiels des vorliegenden Verfahrens; und
- Fig. 2: ein schematisches Blockdiagram eines Ausführungsbeispiels des vorliegenden Systems.

In den Figuren der Zeichnungen bezeichnen gleiche Bezugszeichen gleiche oder funktionsgleiche Elemente, Bauteile oder Komponenten, soweit nichts Gegenteiliges angegeben ist.

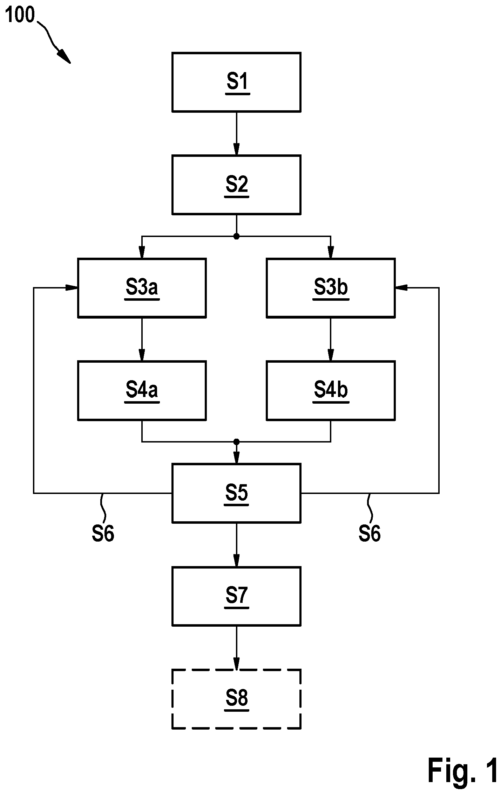

Figur 1 zeigt ein schematisches Flussdiagramm eines Verfahrens zum Trainieren eines genetisch-symbolischen Regressionsmodells 102 zur Ursachenermittlung einer Degradation eines Energiespeichers.

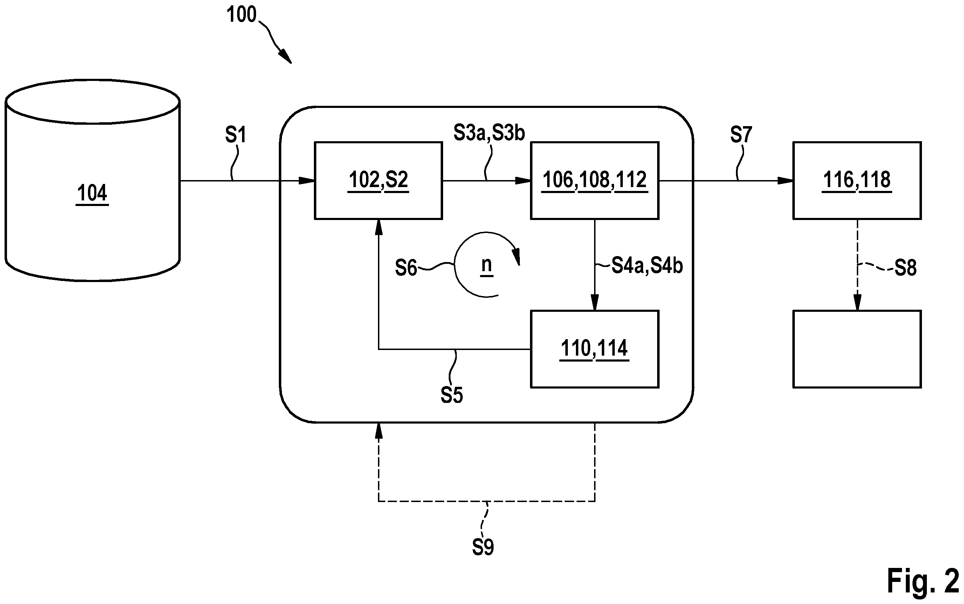

Das Verfahren kann in einer beliebigen Ausführungsform zumindest teilweise durch ein System 100 ausgeführt werden (siehe Fig. 2), das hierzu mehrere nicht näher dargestellte Komponenten, beispielsweise eine oder mehrere Bereitstellungseinrichtungen und/oder mindestens eine Auswerte- und Recheneinrichtung umfassen kann. Es versteht sich, dass die Bereitstellungseinrichtung gemeinsam mit der Auswerte- und Recheneinrichtung ausgebildet sein kann, oder von dieser unterschiedlich sein kann. Ferner kann das System eine Speichereinrichtung und/oder eine Ausgabeeinrichtung und/oder eine Anzeigeeinrichtung und/oder eine Eingabeeinrichtung umfassen.

Das computerimplementierte Verfahren umfasst mindestens die folgenden Schritte:
In einem Schritt S1 erfolgt ein Bereitstellen von Trainingsdaten 104, umfassend Betriebsdaten und/oder Betriebsparameter des Energiespeichers. Die Betriebsdaten und/oder Betriebsparameter weisen vorzugsweise einen zeitreihenbasierten Betriebsstrom und/oder eine zeitreihenbasierte Betriebstemperatur und/oder eine zeitreihenbasierte Beschleunigung und/oder eine zeitreihenbasierte Betriebs- und/oder Zellspannung auf.

In einem Schritt S2 erfolgt ein Generieren, mittels des genetisch-symbolischen Regressionsmodells 102, einer Zufallsbaum-Population von Gleichungen zur Ursachenermittlung der Degradation.

In einem Schritt S3a erfolgt ein Auswählen von mindestens zwei Zufallsbaum-Gleichungen 106, 108 der Zufallsbaum-Population von Gleichungen, zum Kreuzen S4a der mindestens zwei Zufallsbaum-Gleichungen 106, 108 zum Erzeugen von mindestens einer gekreuzten Zufallsbaum-Gleichung 110. Das Kreuzen S4a weist ein Kombinieren der mindestens zwei Zufallsbaum-Gleichungen, insbesondere unter Berücksichtigung von mindestens einer Randbedingung und/oder einer Leistung bei der Ursachenermittlung auf.

In einem zu dem Schritt S3a alternativ oder ergänzend ausführbaren Schritt S3b erfolgt ein Auswählen von mindestens einer Zufallsbaum-Gleichung 112 der Zufallsbaum-Population von Gleichungen, zum Mutieren S4b der mindestens einen Zufallsbaum-Gleichung 112 zum Erzeugen von mindestens einer mutierten Zufallsbaum-Gleichung 114. Das das Mutieren S4b weist ein zufälliges Verändern und/oder Kombinieren mindestens eines Teils der mindestens einen Zufallsbaum-Gleichung auf.

In einem Schritt S5 erfolgt ein Hinzufügen der gekreuzten und/oder mutierten Zufallsbaum-Gleichung 110, 114 zu der Zufallsbaum-Population von Gleichungen.

In einem Schritt S6 erfolgt ein Durchführen der Schritte S3a, S4a und/oder S3b, S4b und S5 für eine vorbestimmte Anzahl n von Generationen.

In einem Schritt S7 erfolgt ein Auswählen derjenigen Zufallsbaum-Gleichung 116 aus der Zufallsbaum-Population von Gleichungen, die basierend auf einer Bewertungsmetrik die beste Ursachenermittlung der Degradation des Energiespeichers angibt, um derart das trainierte genetisch-symbolische Regressionsmodell 118 bereitzustellen.

In einem optionalen Schritt S8 kann ein Durchführen einer Merkmalswichtigkeitsanalyse bezüglich der in Schritt S7 ausgewählten Zufallsbaum-Gleichung 116 erfolgen. Die Merkmalswichtigkeitsanalyse kann ein Erzeugen mindestens einer partiellen Ableitung der in Schritt S7 ausgewählten Zufallsbaum-Gleichung 116 in Bezug auf mindestens eine Gleichungsvariable aufweisen. Die Merkmalswichtigkeitsanalyse kann ein Analysieren der dem Schritt S7 zugrundeliegenden Zufallsbaum-Population von Gleichungen aufweisen.

Zum Optimieren des genetisch-symbolischen Regressionsmodells eine optionale Hyperparameteranpassung und/oder eine Hyperparameteranalyse in einem Schritt S9 während des nach Abschluss oder während Modelltrainings durchgeführt werden.

Das so trainierte genetisch-symbolische Regressionsmodell kann somit zur Ursachenermittlung einer Degradation eines Energiespeichers verwendet werden. Der Energiespeicher kann einen elektrischen Energiespeicher oder einen elektro-chemischen Energiespeicher oder einen elektro-mechanischen Energiespeicher aufweisen. Der elektrische Energiespeicher kann eine Batterie oder eine Brennstoffzelle aufweisen. Das Verfahren kann insbesondere zur Ursachenermittlung einer Stackdegradation der Brennstoffzelle und/oder der Batterie ausgebildet sein.

## Patentansprüche

1. Verfahren zum Trainieren eines genetisch-symbolischen Regressionsmodells (102) zur Ursachenermittlung einer Degradation eines Energiespeichers, das Verfahren aufweisend:
- Bereitstellen (S1) von Trainingsdaten (104), umfassend Betriebsdaten und/oder Betriebsparameter des Energiespeichers;
- Generieren (S2), mittels des genetisch-symbolischen Regressionsmodells (102), einer Zufallsbaum-Population von Gleichungen zur Ursachenermittlung der Degradation;
- Auswählen (S3a) von mindestens zwei Zufallsbaum-Gleichungen der Zufallsbaum-Population von Gleichungen, zum Kreuzen (S4a) der mindestens zwei Zufallsbaum-Gleichungen zum Erzeugen von mindestens einer gekreuzten Zufallsbaum-Gleichung; und/oder
- Auswählen (S3b) von mindestens einer Zufallsbaum-Gleichung der Zufallsbaum-Population von Gleichungen, zum Mutieren (S4b) der mindestens einen Zufallsbaum-Gleichung zum Erzeugen von mindestens einer mutierten Zufallsbaum-Gleichung;
- Hinzufügen (S5) der gekreuzten und/oder mutierten Zufallsbaum-Gleichung zu der Zufallsbaum-Population von Gleichungen;
- Durchführen (S6) der Schritte (S3) bis (S5) für eine vorbestimmte Anzahl (n) von Generationen; und
- Auswählen (S7) derjenigen Zufallsbaum-Gleichung aus der Zufallsbaum-Population von Gleichungen, die basierend auf einer Bewertungsmetrik die beste Ursachenermittlung der Degradation des Energiespeichers angibt, um derart das trainierte genetisch-symbolische Regressionsmodell bereitzustellen.

2. Verfahren nach Anspruch 1, wobei die Betriebsdaten und/oder Betriebsparameter einen zeitreihenbasierten Betriebsstrom und/oder eine zeitreihenbasierte Betriebstemperatur und/oder eine zeitreihenbasierte Beschleunigung und/oder eine zeitreihenbasierte Betriebs- und/oder Zellspannung aufweisen.

3. Verfahren nach Anspruch 1 oder 2, wobei das Kreuzen (S4a) ein Kombinieren der mindestens zwei Zufallsbaum-Gleichungen, insbesondere unter Berücksichtigung von mindestens einer Randbedingung und/oder einer Leistung bei der Ursachenermittlung aufweist.

4. Verfahren nach einem der vorstehenden Ansprüche, wobei das Mutieren (S4b) ein zufälliges Verändern und/oder Kombinieren mindestens eines Teils der mindestens einen Zufallsbaum-Gleichung aufweist.

5. Verfahren nach einem der vorstehenden Ansprüche, wobei zum Optimieren des genetisch-symbolischen Regressionsmodells eine Hyperparameteranpassung und/oder eine Hyperparameteranalyse während des nach Abschluss oder während Modelltrainings durchgeführt wird.

6. Verfahren nach einem der vorstehenden Ansprüche, wobei der Energiespeicher einen elektrischen Energiespeicher oder einen elektro-chemischen Energiespeicher oder einen elektro-mechanischen Energiespeicher aufweist.

7. Verfahren nach Anspruch 6, wobei der elektrische Energiespeicher eine Batterie oder eine Brennstoffzelle aufweist, und das Verfahren zur Ursachenermittlung einer Stackdegradation der Brennstoffzelle und/oder einer Degradation der Batterie ausgebildet ist.

8. Verfahren nach einem der vorstehenden Ansprüche, ferner aufweisend: Durchführen (S8) einer Merkmalswichtigkeitsanalyse bezüglich der in Schritt S7 ausgewählten Zufallsbaum-Gleichung.

9. Verfahren nach Anspruch 8, wobei die Merkmalswichtigkeitsanalyse ein Erzeugen mindestens einer partiellen Ableitung der in Schritt S7 ausgewählten Zufallsbaum-Gleichung in Bezug auf mindestens eine Gleichungsvariable aufweist.

10. Verfahren nach Anspruch 8 oder 9, wobei die Merkmalswichtigkeitsanalyse ein Analysieren der dem Schritt S7 zugrundeliegenden Zufallsbaum-Population von Gleichungen aufweist.

11. Verwendung des gemäß dem Verfahren nach einem der Ansprüche 1-10 trainierten genetisch-symbolischen Regressionsmodells zur Ursachenermittlung einer Degradation eines Energiespeichers.

12. System (100) zum Trainieren eines genetisch-symbolischen Regressionsmodells zur Ursachenermittlung einer Degradation eines Energiespeichers, das System (100) aufweisend eine Auswerte- und/oder Recheneinrichtung, die dazu ausgebildet ist, mindestens die nachfolgenden Schritte auszuführen:
- Bereitstellen (S1) von Trainingsdaten, umfassend Betriebsdaten und/oder Betriebsparameter des Energiespeichers;
- Generieren (S2), mittels des genetisch-symbolischen Regressionsmodells, einer Zufallsbaum-Population von Gleichungen zur Ursachenermittlung der Degradation;
- Auswählen (S3a) von mindestens zwei Zufallsbaum-Gleichungen der Zufallsbaum-Population von Gleichungen, zum Kreuzen (S4a) der mindestens zwei Zufallsbaum-Gleichungen zum Erzeugen von mindestens einer gekreuzten Zufallsbaum-Gleichung; und/oder
- Auswählen (S3b) von mindestens einer Zufallsbaum-Gleichung der Zufallsbaum-Population von Gleichungen, zum Mutieren (S4b) der mindestens einen Zufallsbaum-Gleichung zum Erzeugen von mindestens einer mutierten Zufallsbaum-Gleichung;
- Hinzufügen (S5) der gekreuzten und/oder mutierten Zufallsbaum-Gleichung zu der Zufallsbaum-Population von Gleichungen;
- Durchführen (S6) der Schritte (S3) bis (S5) für eine vorbestimmte Anzahl (n) von Generationen; und
- Auswählen (S7) derjenigen Zufallsbaum-Gleichung aus der Zufallsbaum-Population von Gleichungen, die basierend auf einer Bewertungsmetrik die beste Ursachenermittlung der Degradation des Energiespeichers angibt, um derart das trainierte genetisch-symbolische Regressionsmodell bereitzustellen.

13. Computerprogramm mit Programmcode, um zumindest Teile eines Verfahrens nach einem der Ansprüche 1 bis 10 auszuführen, wenn das Computerprogramm auf einem Computer ausgeführt wird.

14. Computerlesbarer Datenträger mit Programmcode eines Computerprogramms, um zumindest Teile eines Verfahrens nach einem der Ansprüche 1 bis 10 auszuführen, wenn das Computerprogramm auf einem Computer ausgeführt wird.
